(19) Europäisches Patentamt
European Patent Office
Office européen des brevets

(11) EP 0 395 917 B1

(12) EUROPÄISCHE PATENTSCHRIFT

(45) Veröffentlichungstag und Bekanntmachung des Hinweises auf die Patenterteilung:
**25.06.1997 Patentblatt 1997/26**

(51) Int Cl.6: **G03F 7/40**

(21) Anmeldenummer: **90106853.6**

(22) Anmeldetag: **10.04.1990**

(54) **Photostrukturierungsverfahren**

Photographic structuring process

Procédé de structuration photographique

(84) Benannte Vertragsstaaten:
**BE CH DE ES FR GB IT LI NL SE**

(30) Priorität: **24.04.1989 DE 3913433**
**24.04.1989 DE 3913432**

(43) Veröffentlichungstag der Anmeldung:
**07.11.1990 Patentblatt 1990/45**

(73) Patentinhaber: **SIEMENS AKTIENGESELLSCHAFT**
**80333 München (DE)**

(72) Erfinder:
- **Sebald, Michael, Dr. rer. nat.**
  **D-8521 Hessdorf (DE)**
- **Leuschner, Rainer, Dr. rer. nat.**
  **D-8521 Grossenseebach (DE)**
- **Sezi, Recai, Dr.-Ing.**
  **D-8551 Röttenbach (DE)**
- **Birkle, Siegfried, Dr. rer. nat.**
  **D-8552 Höchstadt (DE)**
- **Ahne, Hellmut, Dr.**
  **D-8551 Röttenbach (DE)**

(56) Entgegenhaltungen:
**EP-A- 0 052 806** **EP-A- 0 130 581**

EP 0 395 917 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft ein Verfahren zur Variation der Breite einer Photoresiststruktur sowie ein dafür geeignetes Photoresistsystem.

Bei der photolithographischen Erzeugung von Resiststrukturen wird die Auflösung, das heißt die kleinstmögliche noch abbildbare Struktur (CD), bestimmt durch die photolithographischen Eigenschaften des Resistmaterials, die verwendete Belichtungswellenlänge und die numerische Apertur der Abbildungsoptik (NA). Die Grenze der Auflösung wird dann überschritten, wenn sowohl Linien- als auch Grabenstrukturen auf der Maske unabhängig von ihrer Dimension innerhalb einer gegebenen Genauigkeit nicht mehr maßgetreu in den Resist übertragen werden können. Die nachfolgende Gleichung verdeutlicht, wie die Auflösung von verschiedenen physikalischen Parametern abhängig ist.

$$CD = k \frac{\lambda}{NA}$$

Man sieht, daß die Auflösung im wesentlichen nur noch durch die Reduzierung der Belichtungswellenlänge oder durch Vergrößerung der numerischen Apertur gesteigert werden kann. Der Faktor k ist dabei verfahrens- und anlagenspezifisch und zeigt bei bereits optimierten Anlagen nur eine geringe Schwankungsbreite. Heute verwendete Photoresists arbeiten bei einer Belichtungswellenlänge im nahen UV (NUV) bei 436 bzw. 365 nm. Damit lassen sich hochaufgelöste Strukturen im Sub-μm-Bereich (1 bis 0,5 μm) erreichen. Resists für Belichtungen im tiefen UV (DUV) werden gegenwärtig noch entwickelt und sind noch nicht kommerziell erhältlich.

Strukturen im Sub-Halb-μm-Bereich (0,5 bis 0,2 μm) können heute nur mit Hilfe aufwendiger und teuerer Verfahren wie zum Beispiel Elektronenstrahl- und Röntgenlithographie erzeugt werden.

Die Mehrzahl der verwendeten Photoresists für den Sub-μm-Bereich arbeiten positiv und bestehen aus einem Basispolymeren und einer photoaktiven Komponente. Die photolithographischen Eigenschaften des Resists sind durch den Kontrast und die Empfindlichkeit des Materials charakterisiert. Der Kontrast wird dabei aus der Steigung einer Kurve ermittelt, bei der der chemische Abtrag einer belichteten Photoresistschicht im Entwicklungsverfahren gegen den Logarithmus der entsprechenden Lichtintensität aufgetragen ist. Als Folge eines hohen Kontrastes können an den Grenzen zwischen belichteten und unbelichteten Bereichen einer Photoresistschicht steile Flanken in den Photoresiststrukturen erhalten werden. Als Empfindlichkeit wird im wesentlichen die Lichtempfindlichkeit eines Photoresists bezeichnet, welche aus ökonomischen Gründen zu steigern ist. Eine höhere Empfindlichkeit schafft eine kürzere Belichtungszeit, welche den kostenintensivsten Teil des Lithographieverfahrens darstellt.

Die Photoresiststrukturen werden auf Substraten erzeugt, die Oberflächen aus zum Beispiel Halbleitern, Keramik oder Metall aufweisen. Sie dienen als eng aufliegende Hilfsmaske für physikalische oder chemische Behandlung der Substratoberfläche in den Bereichen, die nicht von der Photoresiststruktur bedeckt sind. Beispielsweise weisen diese Bereiche Loch- oder Grabenform auf. Bei der bislang stetig gesteigerten und immer noch zunehmenden Miniaturisierung von mikroelektronischen Bauelementen und der damit einhergehenden Steigerung der Integrationsdichte von Schaltungen bzw. elektronischen Speicherbausteinen ist es ein wichtiges Ziel, diese Resistgräben weiter zu verkleinern bzw. zu verengen. Ein engerer Graben erlaubt zum Beispiel die Herstellung einer engeren Trenchzelle oder einer schmaleren Leiterbahn. Ziel ist es dabei, die Miniaturisierung in fertigungsfreundlichen, reproduzierbaren und ökonomischen Verfahren zu erreichen, die Auflösungsgrenze des Photoresists zu steigern oder gar Strukturen zu erzeugen, die jenseits der Auflösungsgrenze einer verwendeten Abbildungstechnik liegen.

Für die Realisierung von Strukturdimensionen, die jenseits der Auflösungsgrenze der verwendeten lithographischen Techniken liegen, sind zur Zeit zwei prinzipielle Verfahren bekannt.

So ist zum Beispiel einem Beitrag von Y. Kawamoto et al., "A Half Micron Technology For An Experimental 16 MBIT DRAM Using i-line Stepper", VLSI Symposium, S. Diego 1988, eine Grabenverengungstechnik für eine Belichtungswellenlänge von 365 nm zu entnehmen. Das Verfahren beruht auf einem dreischichtigen Aufbau, bei der die oberste Schicht ein Topresist ist, welcher positiv arbeitet. Die lithographisch erzeugten Topresiststrukturen von 0,6 μm werden durch Plasmaabscheidung von Siliziumdioxid vergrößert, bzw. die lichte Weite von Resistgräben verringert. Im daran anschließenden Plasmaätzprozeß werden diese Resiststrukturen auf eine darunterliegende Spin-on-Glass-Zwischenschicht übertragen. Dabei bleiben nur an den Flanken der Photoresiststruktur sogenannte Siliziumdioxidspacer bestehen, die die Weite der ursprünglich 0,6 μm breiten Photoresistgräben auf 0,4 μm reduzieren. Diese Gräben werden in einem weiteren anisotropen Ätzverfahren mittels Sauerstoffplasma in die zuunterst liegende organische Planarisierungsschicht übertragen.

Mit dieser Technik kann zum Beispiel die Speicherzellenfläche eines elektronischen Speicherbausteines um ca. 30 Prozent reduziert und die Integrationsdichte damit entsprechend erhöht werden. Nachteilig wirken sich dabei jedoch der Mehrlagenaufbau und die dadurch benötigten drei Plasmaätzschritte aus, die aufwendig durchzuführen und wenig fertigungsfreundlich sind.

Ein anderer Weg zur Erzeugung von Strukturen unterhalb der Auflösungsgrenze einer optischen NUV-Lithographie

wird von B. D. Cantos, R. D. Remba, "A Reliable Method For 0.25-Micron Gate MESFET Fabrication Using Optical Photolithography", J. Electrochem. Soc. Acc. Br. Comm., 1311-12 (1988) beschrieben. In einem Dreischichtaufbau wird als obere Topresistschicht ein sogenannter Image-Reversal-Resist aufgebracht und über eine Maske belichtet. Nach einem Temperschritt und anschließender Flutbelichtung werden durch Überentwicklung in einem aggressiven Entwickler in den belichteten Bereichen Resiststege mit einer Breite von 0,25 µm erhalten, wobei auf der Maske Strukturen von 0,65 µm Breite vorgegeben waren. Darauf wird nun eine Aluminiumschicht aufgedampft und in einem Lift-off-Verfahren "entwickelt". Durch Abheben der Topresiststege samt der darüberliegenden Aluminiumschicht werden in den Gräben der Topresistschicht Aluminiumstege mit 0,25 µm Breite erhalten. Die Übertragung dieser Aluminiumstruktur auf die darunterliegende organische Planarisierungsschicht samt einer isolierenden Zwischenschicht erfolgt in einem Sauerstoffplasma.

Auch dieses Verfahren besitzt aufgrund seiner Vielzahl an Einzelprozeßschritten eine geringe Prozeßtoleranz und damit eine geringe Fertigungsfreundlichkeit. Außerdem sind auf diesem Weg nur Grabenstrukturen bis 0,25 µm Breite erhältlich bzw. reproduzierbar.

Weitere Probleme ergeben sich in der sogenannten Zweilagentechnik. Hier wird ein zu strukturierender Photoresist in dünner Schicht als Topresist über einer unteren planarisierenden ersten Resistschicht (Bottomresist) aufgebracht. Die ganz normal erzeugte Topresiststruktur wird schließlich in einem anisotropen Ätzverfahren, zum Beispiel im Sauerstoff/RIE-Plasma, in die Bottomresiststruktur übertragen, wobei die Topresiststruktur als Ätzmaske dient.

Dabei tritt wegen des prinzipiell nicht zu vermeidenden isotropen Anteils des ansonsten überwiegend anisotrop wirkenden Ätzschrittes eine Unterätzung der Bottomresiststrukturen ein, die sich in konkaven Strukturflanken bemerkbar macht. So werden bei bekannten Verfahren in der Zweilagentechnik zum Beispiel siliziumhaltige Topresists mit Siliziumanteilen um ca. 10 Gewichtsprozent verwendet. Bei der Entwicklung und nachfolgenden Strukturübertragung in den Bottomresist werden dort jedoch nur Strukturen erhalten, die mindestens 10 Prozent schmaler sind, als die auf der Maske vorgegebenen Strukturen.

In der europäischen Patentanmeldung EP-A 0 136 130 ist ein Verfahren beschrieben, in dem eine aus Novolak bestehende Topresiststruktur mit gasförmigem Titanchlorid behandelt wird, um dessen Ätzresistenz gegenüber einem $O_2$-RIE-Ätzplasma zu verbessern. Wegen der jedoch nur oberflächlich ablaufenden Reaktion des Topresists mit dem Titanchlorid wird auch bei diesem Verfahren ein lateraler Maßverlust bei der Übertragung der Topresiststrukturen auf den Bottomresist erhalten, der bei Sub-µm-Strukturen im Bereich von 0,5 µm nicht tolerabel ist. Außerdem kann bei nicht vollständiger Umsetzung des hydrolisierbaren Chlors am Titan eine spätere Kontamination der Scheibe bzw. der Apparaturen mit Hcl in nachfolgenden Prozeßschritten nicht ausgeschlossen werden.

Ein weiteres Verfahren zur Vergütung von Topresiststrukturen wird in der US-PS 4 690 838 vorgeschlagen, bei dem der Topresist nach der Entwicklung mit gasförmigen Reagenzien wie Hexamethyldisilazan, Chlorsilanen oder Aminosilanen behandelt wird. Auch hier entsteht bei der Strukturübertragung ein lateraler Maßverlust, da die Vergütung lediglich an der Oberfläche bzw. an Phasengrenzen stattfindet.

Eine ausführliche kritische Würdigung von bekannten Verfahren der Zweilagentechnik ist einem Artikel von Sezi et al in SPIE Vol. 811 (1987), Seiten 712 bis 179 zu entnehmen.

Aus der EP-A 0 052 806 ist ein Verfahren zur Beeinflussung von Halbtonbildern bei lithographischen Druckverfahren bekannt. Mit einem Schwellungs- und Vernetzungsmittel wird dabei der Grad der Flächenbedeckung des Halbtonbildes erhöht, um die Farbtönung des Bildes zu beeinflussen.

Aufgabe der vorliegenden Erfindung ist es, ein Verfahren zur Verengung von Resistgräben anzugeben, welches bei einer beliebigen gegebenen Belichtungswellenlänge mit wenigen und einfachen Prozeßschritten in fertigungsfreundlicher und reproduzierbarer Art und Weise durchzuführen ist, welches auch in Zweilagentechnik anwendbar ist und welches sowohl eine exakte 1:1 Strukturübertragung als auch eine Grabenverengung bis unter die optische Auflösungsgrenze erlaubt.

Diese Aufgabe wird durch ein Verfahren gelöst, bei dem

- auf einem Substrat ein Photoresist aufgebracht, belichtet und entwickelt wird, wobei die so entstandene Photoresiststruktur noch funktionelle Gruppen aufweist, die für die chemische Anbindung einer weiteren Verbindung geeignet sind, die ausgewählt sind aus Anhydrid, Epoxid, Polyurethan, Poly(meth)acrylat, Polyester, Polyether, Amid, Phenol und Thioester,

- die Photoresiststruktur mit einem Aufweitungsagens behandelt wird, wobei die im Aufweitungsagens enthaltene Aufweitungskomponente mit den funktionellen Gruppen in der Photoresiststruktur eine chemische Verknüpfung eingeht, wobei die zur Reaktion geeignete chemische Funktion der Aufweitungskomponente eine Hydroxyl- oder Aminogruppe ist, und wobei ein Volumenzuwachs der Photoresiststruktur erzielt wird und

- das Ausmaß der durch den Volumenzuwachs bedingten lateralen Verbreiterung der Resiststrukturen im Bereich von einigen Nanometern bis einige Mikrometer einstellbar ist durch zumindest eine der Maßnahmen a), b) und c):

a) Erhöhung der Konzentration der Aufweitungskomponente im Aufweitungsagens

b) Erhöhung der Temperatur bei der Behandlung mit dem Agens

c) Erhöhung der Behandlungsdauer mit dem Agens.

Weiterhin liegt es im Rahmen der Erfindung, daß die Aufweitungskomponente hydrolysestabil ist, in einer waßrigalkoholischen Lösung oder Emulsion eingesetzt wird, wobei die Behandlung mit dem Aufweitungsagens bezüglich Atmosphäre, Druck und Temperatur unter Normalbedingungen (Raumtemperatur usw.) durchgeführt werden kann. Weitere Ausgestaltungen der Erfindung sowie ein für dieses Verfahren geeignetes Photoresistsystem sind den Unteransprüchen zu entnehmen.

Das erfindungsgemäße Verfahren kann ein einfacher "naßchemischer" Prozeß sein, der aufgrund des verwendeten Aufweitungsagens zum Beispiel in wäßrigem Medium in einfachen offenen Apparaturen durchgeführt werden kann. Mit ihm können lithographisch erzeugte Resistgraben beliebiger Form durch eine einfache chemische Aufweitung angrenzender Resiststege auf ein Maß verengt werden, welches weit jenseits der Auflösungsgrenze des verwendeten Lithographieverfahrens liegt. Damit können auch im Substrat Strukturen mit einer beliebig kleinen Dimension erzeugt werden. Dabei ist das Verfahren unabhängig von der Art des Substrats, welches zum Beispiel ein Halbleiter, eine Oxidschicht, eine Keramik oder Metall ist oder bei einer Zweilagentechnik auch ein planarisierender Bottomresist.

Auch mit Hilfe von NUV-Photolithographie erzeugte Resiststrukturen, die ein 1:1-Verhältnis von Steg:Graben-Dimensionen aufweisen, lassen sich mit dem erfindungsgemäßen Verfahren gezielt so stark aufweiten, daß die verbleibenden verengten Resistgräben laterale Abmessungen zwischen 0 nm und dem ursprünglichen Wert besitzen. Beispielsweise können 0,5 µm breite Gräben mit 0,5 µm breiten Stegen auf einen beliebigen Wert zwischen 0 und 500 nm eingestellt werden. Mit einer so behandelten Photoresiststruktur lassen sich nun erstmals über photolithographische Verfahren Transistorgatelängen in Dimensionen zwischen 0 und 500 nm einfach und reproduzierbar darstellen.

In derselben Weise kann die Fläche einer runden bzw. rechteckigen Resistvertiefung gezielt und unter Beibehaltung ihrer Form reduziert werden. So lassen sich zum Beispiel Kontaktlöcher oder Trenchzellen in nahezu jeder beliebigen Dimension darstellen.

Weiterhin liegt es im Rahmen der Erfindung, daß mit der Aufweitung der Struktur ein Maßvorhalt erzeugt wird, der genau dem Maßverlust entspricht, den die Strukturübertragung von der zweiten in die erste Resistschicht oder in das Substrat erzeugt.

Mit dem erfindungsgemäßen Verfahren kann daher nun erstmals ein Maßverlust bei der Strukturübertragung von dem Topresist in den Bottomresist bzw. in den Wafer bewußt in Kauf genommen werden. Mit der Strukturaufweitung durch die chemische Behandlung kann ein jeder Maßverlust ausgeglichen werden und so eine hundertprozentig exakte 1:1 Strukturübertragung relativ zur Maske gewährleistet werden. Das Verfahren ist dabei wenig aufwendig durchzuführen und enthält gegenüber der einfachsten Zweilagentechnik lediglich einen zusätzlichen Verfahrensschritt. Ein weiterer Vorteil des erfindungsgemäßen Verfahrens ergibt sich aus einer sich verringernden Abhängigkeit von der Entwicklungszeit des Topresists. Während bisher eine Überentwicklung der Topresiststrukturen strikt vermieden werden mußte, kann nun eine längere Entwicklungszeit eingestellt werden und somit in einem Bereich gearbeitet werden, bei dem der Materialabtrag während des Entwicklungsverfahrens eine geringere Abhängigkeit von der Entwicklungsdauer zeigt. Das Verfahren wird also gegenüber einem weiteren Parameter unkritisch und somit genauer in der Maßhaltigkeit der erzeugten Strukturen.

Beim Aufweiten der Strukturen wird gleichzeitig auch die Schichtdicke der Strukturen verstärkt und so dem Abtrag dieser Strukturen im Ätzplasma entgegengewirkt.

Das erfindungsgemäße Verfahren ist nicht nur von dem Substrat, sondern auch von der verwendeten Belichtungswellenlänge, der Abbildungstechnik und weitgehend auch vom verwendeten Resist unabhängig. Es spielt auch keine Rolle, ob ein Positiv- oder Negativresist verwendet wird.

Ein weiterer Vorteil des Verfahrens liegt darin, daß das Ausmaß der Aufweitung einfach gesteuert werden kann. Dies ist zum Beispiel über die Dauer der Behandlung der Photoresiststruktur mit dem Aufweitungsagens möglich. Bei der Reaktion des Aufweitungsagens mit dem Photoresist handelt es sich um eine stetige Reaktion, bei der die Aufweitungskomponente zunächst in die Photoresiststruktur eindiffundiert, um schließlich mit den dort vorhandenen reaktiven Gruppen des Photoresists zu reagieren. Bei längerer Behandlungsdauer kann das Aufweitungsagens tiefer in die Photoresiststruktur eindiffundieren und so einen stärkeren Volumenzuwachs erzeugen. Bei gegebener Behandlungsdauer ist es auch möglich, das Ausmaß der Aufweitung der Photoresiststrukturen über die Konzentration der Aufweitungskomponente im Aufweitungsagens zu regeln. Nach einfachen Gesetzen der Reaktionskinetik bedingt eine höhere Konzentration eines Reaktanten eine schnellere Reaktion. Bei vorgegebener Reaktionsdauer wird dann ein höherer Umsatz und somit ein höherer Volumenzuwachs der Photoresiststrukturen bzw. eine stärkere Verengung von Resistgräben erhalten. Als diffusionskontrollierte Reaktion ist die Aufweitung auch langsam genug, um sie über die Verfahrensparameter exakt zu kontrollieren.

Die Aufweitungskomponente liegt zum Beispiel in einem Wasser enthaltenden Medium vor, welches eine Lösung oder Emulsion sein kann. Möglich ist auch ein rein wäßriges Medium oder eine beliebige Wasser enthaltende Lösungsmittelmischung, welche als weitere mit Wasser mischbare Komponente bevorzugt Alkohol enthält. Doch auch andere organische Lösungsmittel sind möglich. Die Aufweitungskomponente kann dabei in dem Medium löslich sein, so daß das Agens eine Lösung darstellt. Doch auch eine nicht mit dem Medium mischbare Aufweitungskomponente kann verwendet werden. Erfindungsgemäß wird ein solches Aufweitungsagens dann als Emulsion eingesetzt.

Die aufweitende Behandlung kann auch mit einem in der Gasphase vorliegenden Agens vorgenommen werden. Eine gute Möglichkeit der Steuerung bietet sich dann vor allem über die Temperatur, bei der die Behandlung durchgeführt wird, was natürlich auch für ein Agens in flüssigem Medium gilt. Steigende Temperatur beschleunigt die Aufweitung.

Soll die behandelte Photoresiststruktur in späteren Verfahrensschritten als Ätzmaske dienen, so können mit der Anbindung der Aufweitungskomponente an die Photoresiststruktur gleichzeitig ätzresistente Gruppen in den Resist eingebracht werden. So zeigen zum Beispiel aromatische Gruppierungen eine erhöhte Ätzresistenz gegenüber einem halogenhaltigen Ätzplasma. Andererseits jedoch ist ein Photoresist, der aromatische Strukturen aufweist, für eine Photostrukturierung mit tiefem UV-Licht ungeeignet, da die Aromaten in diesem Wellenlängenbereich verstärkt Licht absorbieren. So kann für die Photostrukturierung ein für tiefes UV-Licht entsprechend transparenter Photoresist verwendet werden und erst später durch die erfindungsgemäße Behandlung ätzresistent gemacht werden.

Doch auch gegenüber anderen Ätzverfahren resistente Gruppen lassen sich einführen. Ein siliziumhaltiges Aufweitungsagens bzw. eine siliziumhaltige Aufweitungskomponente kann die Ätzresistenz gegen ein sauerstoffhaltiges Ätzplasma erzeugen oder verstärken.

Im Sauerstoffplasma bilden sich aus den siliziumhaltigen Gruppen schwerflüchtige Oxide, die ein weiteres Oxidieren und darauf folgendes Abtragen darunterliegender Resistbereiche erschweren bzw. verhindern. Neben Silizium können auch andere Elemente die Ätzresistenz im Sauerstoffplasma stärken, sofern sie im Sauerstoffplasma nicht flüchtige Oxide bilden, wie zum Beispiel Zinn. Bei Verwendung einer siliziumhaltigen Aufweitungskomponente ist es weiterhin von Vorteil, wenn Si-O-Strukturen in der siliziumhaltigen Aufweitungskomponente vorgebildet sind. Diese erleichtern ein direktes Umsetzen zu Siliziumdioxid, wobei weniger im Sauerstoffplasma flüchtige siliziumorganische Verbindungen entstehen.

Die Anknüpfung einer Aufweitungskomponente gelingt schon, wenn lediglich eine funktionelle Gruppe an der Aufweitungskomponente mit einer reaktiven Gruppe der Photoresiststruktur reagieren kann. Eine noch bessere Anbindung der Aufweitungskomponente an die Resiststruktur erfolgt jedoch, wenn die Aufweitungskomponente zumindest zwei funktionelle Gruppen trägt. So kann die Aufweitungskomponente nicht nur lose angebunden werden, sondern kann durch eine "Zweipunktbefestigung" eine Vernetzung der Resiststruktur bewirken. Diese stärkere Vernetzung kann zum einen die Ätzresistenz weiter erhöhen, zum andern jedoch auch physikalische Eigenschaften der Resiststrukturen in gewünschter Weise verbessern. Ein vernetzter Resist wird härter und besitzt auch einen höheren Schmelzpunkt bzw. Erweichungs- oder Fließpunkt. Gerade letzterer ist für die spätere Verwendung der Resiststruktur als Maske für weitere Strukturierungsprozesse von Bedeutung. Treten bei solch einem Strukturierungsprozeß erhöhte Temperaturen auf, so können während dieses Prozesses die Resiststrukturen verfließen und machen so eine maßstabsgenaue Strukturübertragung unmöglich. Daher ist ein erhöhter Fließpunkt einer Photoresiststruktur immer von Vorteil. Auch siliziumhaltige Aufweitungskomponenten tragen bevorzugt mehrere funktionelle Gruppen. Dadurch wird verhindert, daß durch den Oxidationsprozeß im Sauerstoffplasma die Verknüpfung der Aufweitungskomponente an den Resist gelöst wird, bevor der siliziumhaltige Rest in nichtflüchtiges Siliziumoxid umgewandelt ist. Jede weitere funktionelle Gruppe, bzw. jede weitere Verknüpfungsstelle der Aufweitungskomponente mit der Resiststruktur setzt somit die Flüchtigkeit von Oxidationsprodukten im Sauerstoffplasma herab.

Weitere Forderungen an die Aufweitungskomponente betreffen zum Beispiel deren Löslichkeit. Zum einen sollte die Aufweitungskomponente im Medium des Aufweitungsagens entweder gut löslich oder zumindest gut emulgierbar sein, zum andern soll aber bei guter Löslichkeit nicht auch die Löslichkeit der behandelten Resiststruktur heraufgesetzt werden. Dies erfordert eine Abwägung zwischen guter Handhabbarkeit des Agens (durch Leichtlöslichkeit) und zwischen den Eigenschaften der behandelten Resiststruktur (Unlöslichkeit). Diese Forderungen entfallen bei einer chemischen Behandlung in der Gasphase.

Die Größe bzw. das Molekulargewicht der Aufweitungskomponente kann beliebig klein sein, ist aber nach obenhin begrenzt. Je größer bzw. je schwerer eine solche Komponente ist, desto schwieriger gestaltet sich die Diffusion der Aufweitungskomponente in eine Resiststruktur hinein. Eine gute Diffusionsfähigkeit der Aufweitungskomponente ist jedoch nötig, um ein ausreichendes Ausmaß der Aufweitung der Resiststruktur durch Behandlung mit dem Aufweitungsagens zu erzielen. Je tiefer die Aufweitungskomponente in die Resiststruktur eindiffundieren kann, umso mehr funktionelle Gruppen stehen ihr zur Reaktion mit der Resiststruktur zur Verfügung, und umso größer ist die erreichbare Aufweitung. Chemisch kann die Diffusionsfähigkeit der Aufweitungskomponente in der Resiststruktur gesteigert werden, wenn das chemische Potentialgefälle der Aufweitungskomponente im Aufweitungsagens zur Resiststruktur hin erhöht wird.

Die Anforderungen an einen im erfindungsgemäßen Verfahren verwendbaren Photoresist sind eine gute Strukturierbarkeit bei gegebener Belichtungswellenlange, das Vorhandensein von nach der Entwicklung noch reaktiven Gruppen zur Reaktion mit der Aufweitungskomponente und eine Unlösbarkeit entwickelter Resiststrukturen im Agens bzw. dessen Medium.

Grundsätzlich geeignet als reaktive Gruppe im Topresist bzw. als funktionelle Gruppe an einem Polymer des Topresists sind zum Beispiel die folgenden Gruppen: Anhydrid oder Amid, Oxiran, Phenole, Thioester, Urethane. Diese Gruppen können im Resist von Anfang an vorliegen oder im Verlaufe des Strukturierungsverfahrens (des Topresists) durch chemische Reaktion herausgebildet oder freigesetzt werden.

Als besonders vorteilhafte funktionelle Gruppe im Photoresist hat sich die Anhydridgruppe, insbesondere die cyclische Anhydridgruppe erwiesen. Diese weist selbst im tiefen UV (DUV, Wellenlänge unter 300 nm) keine erhöhte Absorption auf, was für eine hochauflösende Strukturierung unabdingbar erforderlich ist. Auch die thermisch mechanischen Eigenschaften von Anhydriden, insbesondere die hohen Glasübergangstemperaturen sind für die Anwendung als Photoresist gut geeignet. Mit gängigen photoaktiven komponenten lassen sich mit anhydridhaltigen Photoresists hohe Kontraste bei hoher Auflösung erzielen. Dies ist auf den großen Polaritätsunterschied zurückzuführen, welcher zwischen belichteten und nicht belichteten Bereichen bei der Entwicklung auftritt. Insbesondere bei Positivresists wird die durch die Zersetzung der photoaktiven Komponente bewirkte Hydrophilierung der belichteten Bereiche des Photoresists durch einen geeigneten Entwicklungsvorgang verstärkt. Mit Aminogruppen-haltigen Entwicklern wird die Anhydridfunktion hydrolisiert und so die Ablösung belichteter Bereiche im Entwicklungsvorgang verstärkt bzw. verbessert. Da beim Entwicklungsvorgang die Anhydridfunktion unbelichteter Bereiche (bei Positivresists) unhydrolisiert bleibt, ist sie im erfindungsgemaßen Verfahren auch gut als funktionelle Gruppe zur Anbindung der Aufweitungskomponente geeignet. Letztere sollte in diesem Fall zumindest eine Aminogruppe als funktionelle Gruppe aufweisen.

Für einen üblicherweise aus einem Basispolymeren und einer photoaktiven Komponente bestehenden Photoresist richtet sich die Auswahl der Polymere (für das Basispolymer) vor allem nach der geforderten Transparenz für die gegebene Belichtungswellenlänge, bzw. den Wellenlängenbereich. Auch und insbesondere für den DUV-Bereich geeignet sind alternierende Copolymere aus Maleinsäureanhydrid und Styrol, bzw. aus Maleinsäureanhydrid und Allyltrimethylsilan. Beide Polymere besitzen eine hervorragende Transparenz im DUV-Bereich (zum Beispiel bei 248 nm) und im NUV-Bereich (naher UV-Bereich), eine hohe thermische Stabilität (Glasübergangstemperatur größer 160°C) und hervorragende lithographische Eigenschaften in Verbindung mit herkömmlichen photoaktiven Komponenten, bevorzugt mit Estern der Naphthochinondiazid-4-sulfonsäure, und geeigneten Entwicklern.

Weitere geeignete Polymere, welche die cyclische Anhydridgruppe, aber auch andere für das erfindungsgemäße Verfahren geeignete funktionelle Gruppen enthalten, gehorchen zum Beispiel den folgenden allgemeinen Strukturformeln A bis D, oder sind von Polyurethan, Poly(meth)acrylat, Polyester oder Polyether abgeleitet,

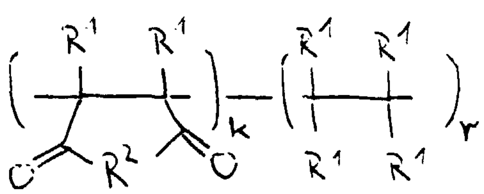

A $0 < \frac{k}{k+r} < 0{,}6$

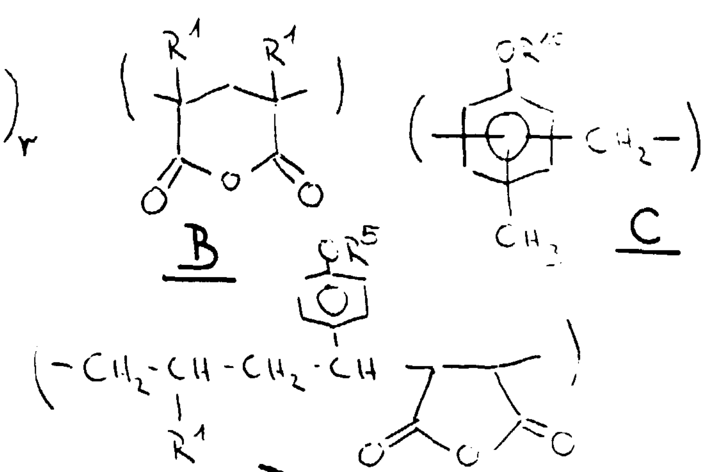

B C D

wobei

$R^1$ gleich H, Alkyl, Aryl, Halogen, Halogen-substituiertes Alkyl bzw. Aryl,

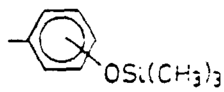, 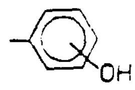, 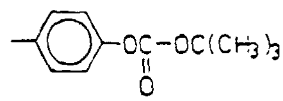,

-COOH, -COOR, $-CH_2Si(CH_3)_3$, $-Si(CH_3)_3$, $-Si(OCH_3)_3$,

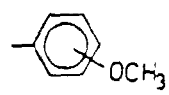

$R^2$ gleich O, NH, S,
$R^5$ gleich H, $CH_3$ und
$R^{10}$ gleich H oder

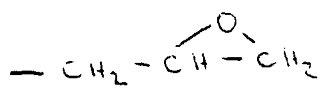

Wie den angeführten Strukturformeln zu entnehmen ist, sind als funktionelle Gruppen zur Anbindung der Aufweitungskomponente bevorzugt Anhydrid-, Carboxyl-, Hydroxyl- und Epoxidgruppen enthalten. Dabei können die (Basis-) Polymeren sowohl chemisch unterschiedliche als auch chemisch einheitliche funktionelle Gruppen tragen.

Die Auswahl der Polymere richtet sich vor allem nach der Transparenz im Bestrahlungswellenlängenbereich. Wie bereits erwähnt, werden für den tiefen UV-Bereich, zum Beispiel 248 nm, im erfindungsgemäßen Verfahren bevorzugt anhydridhaltige Resists verwendet. Diese können den entsprechenden und bereits erwähnten Strukturen gehorchen, oder von weiteren anhydridhaltigen Monomeren abgeleitet sein, die als polymerisierbare Funktion eine Doppelbindung enthalten und beispielsweise einer der allgemeinen Strukturen N, O, P oder Q gehorchen,

N 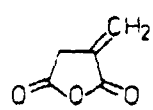 O 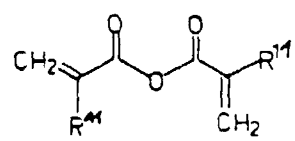

P 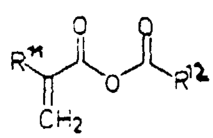 Q 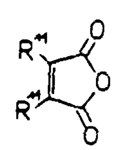

wobei $R^{11}$ für H oder Alkyl stehen und $R^{12}$ einen Alkyl oder Arylrest darstellt.

Entsprechend der Vielfalt der für das erfindungsgemäße Verfahren bzw. für den im Verfahren verwendeten Photoresist geeigneten Basispolymere ist auch die Auswahl der für den Aufweitungsprozeß geeigneten Aufweitungskomponenten umfangreich. Bevorzugte funktionelle Gruppen, die zur Reaktion mit der Resiststruktur bzw. mit dem Basispolymeren des Photoresist geeignet sind, sind beispielsweise aliphatische primäre oder sekundäre Aminogruppen. Besonders bewährt haben sich erfindungsgemäß aromatenhaltige Diamine, zum Beispiel 1,3-Diaminomethyl-benzol und kettenförmige Dimethylsiloxane mit entständigen Aminopropyleinheiten und 1 bis 50, vorzugsweise aber 2 bis 12 Siliziumatomen pro Molekül. Solche Aufweitungskomponenten werden zum Beispiel durch die allgemeinen Strukturformeln G und H dargestellt:

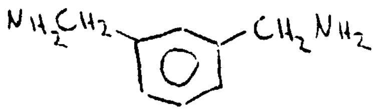

G

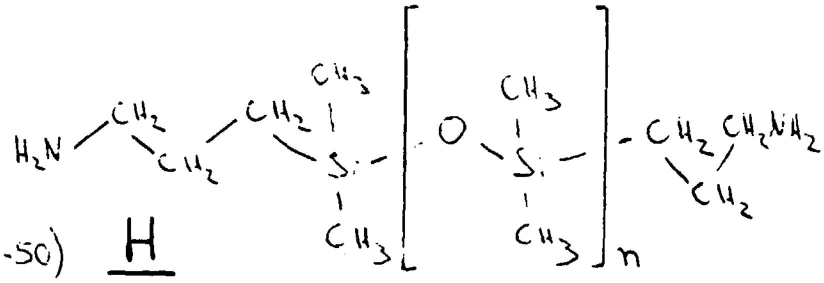

(n=0-50) H

Wird als Basispolymer das bereits erwähnte und gut geeignete Copolymer aus Maleinsäureanhydrid und Styrol eingesetzt, so ist als Aufweitungskomponente das 1,3-Diaminomethylbenzol besonders geeignet. Der allgemeinen Strukturformel H gehorchende Aufweitungskomponenten sind besonders zum Aufweiten von Strukturen geeignet, die das ebenfalls bereits erwähnte Copolymer aus Maleinsäureanhydrid und Allyltrimethylsilan in der Resiststruktur als Basispolymer enthalten.

Weitere Beispiele von Aufweitungskomponenten mit Amino-funktionellen, aber auch mit anderen funktionellen Gruppen lassen sich durch die allgemeinen Strukturformeln I, K, L und M darstellen,

I $R^4-(CH_2)_n-Si R^3_3$

L $(CH_3)_3Si-NH-Si(CH_3)_3$

K 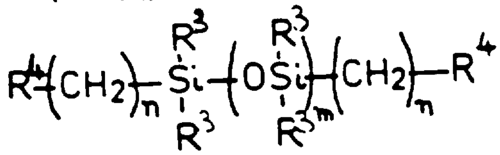

(m = 0 - 30, n = 0 - 3)

M 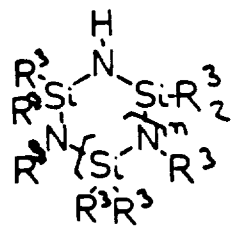

(n ≥ 1)

wobei $R^3$ = H, Alkyl, Aryl, Cycloalkyl
und $R^4$ =

$-OH$, $-NH_2$, $-SH$, $-COOH$, 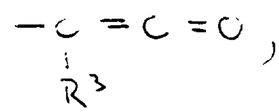,

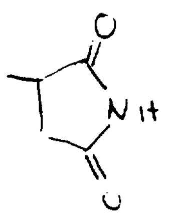, $-NCO$, 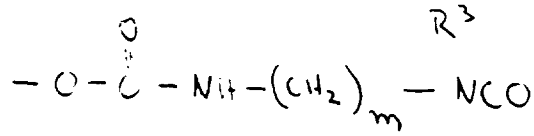,

(m = 1,2,3)

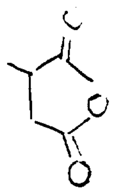; 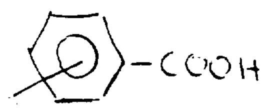; $-NH-CH_2-CH_2-NH_2$;

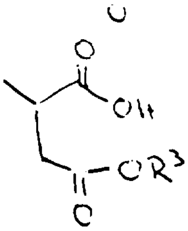; 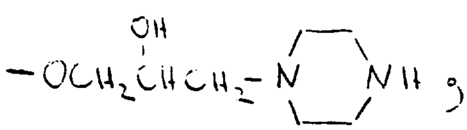; 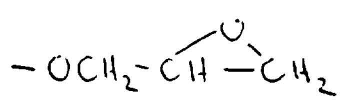

Auch Silsesquioxane sind als Agens geeignet.

Besonders geeignet für das erfindungsgemäße Verfahren sind aliphatische Diaminosiloxane mit 1 bis 50, bevorzugt mit 2 bis 12 Siliziumatomen pro Molekül. Auch Silsesquioxane sind geeignet.

Die erfindungsgemäße Behandlung mit dem Aufweitungsagens kann wie bereits erwähnt bevorzugt unter Normalbedingungen, das heißt Raumtemperatur, Normaldruck und Normalatmosphäre durchgeführt werden. Selbstverständlich kann natürlich auch bei einer erhöhten Temperatur gearbeitet werden, sofern diese unterhalb der Verformungstemperatur der Photoresiststruktur gewählt wird. Mit der Behandlung können Aufweitungen von Resiststegen bzw. allgemeinen Resiststrukturen von wenigen Nanometern bis ca. einige Mikrometer erzielt werden. Durch Steuerung der Behandlung, zum Beispiel auch durch Einstellen der Temperatur, kann das Ausmaß der Aufweitung genau bestimmt werden und mit dem erfindungsgemäßen Verfahren somit eine maßstabsgenaue Verkleinerung bzw. Vergrößerung von Strukturen erzielt werden. Derart aufgeweitete Resiststrukturen können dann als Hilfsmaske für weitere Behandlungen des Substrats, zum Beispiel Ätzen eines Halbleitersubstrats im Halogenplasma, dienen. Wird die aufgeweitete Resiststruktur als Topresist in einem Zweilagenresist über einem planarisierenden Bottomresist eingesetzt, so kann diese Hilfsstruktur in einem Sauerstoffplasma auf den Bottomresist übertragen werden.

Bei der Zweilagentechnik wird ein siliziumfreier Topresist in Kombination mit einem siliziumhaltigen Aufweitungsagens bevorzugt, um die Ätzresistenz speziell in den aufgeweiteten Bereichen zu erhalten.

Für die Erzeugung senkrechter, nicht unterätzter Strukturflanken im Bottomresist kann es aber, je nach Prozeß auch vorteilhaft sein, $O_2$-RIE-resistente Topresiststrukturen mit einem Aufweitungsagens zu behandeln, welches keine $O_2$-RIE-Resistenz verbessernde Elemente enthält. Der Maßverlust in den aufgeweiteten Topresiststrukturen kann dann mit der Unterätzung der Bottomresiststrukturen Schritt halten, wo durch auch hierbei steile Flanken erzeugt werden können. Der dadurch hervorgerufene höhere Schichtabtrag in der Topresiststruktur wird durch eine entsprechend dikkere Aufweitungsschicht aufgefangen, da die Aufweitung nicht nur laterale Verbreiterung der Strukturen sondern auch erhöhte Schichtdicken erzeugt.

Strukturbeispiele für ein derartiges Aufweitungsagens werden durch die allgemeinen Strukturformeln E, F, S, U und T wiedergegeben,

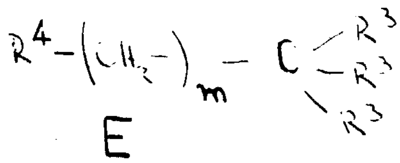
E ,
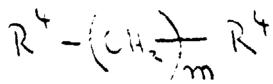
F ,
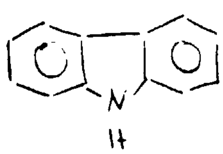
S ,
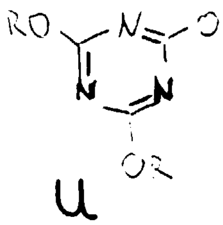
U ,
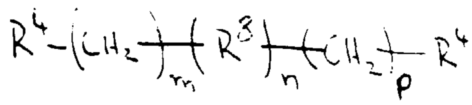
T $(m, p \geq 1, n \geq 0)$

wobei die Reste R unabhängig voneinander für Alkyl, Aryl, oder H stehen,
$R^8$ die Reste

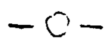 , 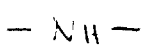 , 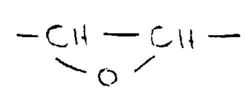 , 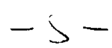 ,

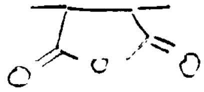 , 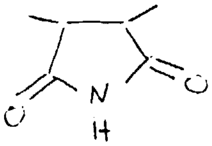 , 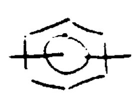 , 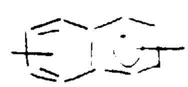

bedeutet und die übrigen allgemein angegebenen Reste die bereits erwähnte Bedeutung haben.

Für die weniger reaktionsfreudigen funktionellen Gruppen am Aufweitungsagens kann es von Vorteil sein, wenn

dem Agens ein Katalysator beigemischt ist, der die Reaktion mit den funktionellen Gruppen des Topresists beschleunigt.

In der Einlagentechnik enthält vorzugsweise weder der Resist noch das Aufweitungsagens Silizium. Dafür wird mit einem Aromaten enthaltenden Aufweitungsagens die für spätere Ätzprozesse wichtige Resistenz gegen Halogenplasma erzeugt.

Werden die entwickelten Resiststrukturen vor der Aufweitung flutbelichtet, so erfolgt eine chemische Aktivierung dieser Strukturen durch photochemische Zersetzung der photoaktiven Komponente. Die Folge ist eine schnellere und stärkere Aufweitung der Strukturen.

Durch die Aufweitung von Resiststegen gelingt somit gleichzeitig die Verengung von Resistgräben bis hinab zu Dimensionen, die die Auflösungsgrenze der verwendeten Lithographie weit unterschreiten. Es können Gräben mit einem Aspektverhältnis bis ca. 50 erzeugt werden, was von keiner bislang bekannten Methode erreicht wird.

Im folgenden wird das erfindungsgemäße Verfahren anhand von acht Ausführungsbeispielen näher erläutert. Es werden dazu zwei ausgewählte Zusammensetzungen für einen Topresist, vier Zusammensetzungen für ein Aufweitungsagens sowie die Ergebnisse von Vorversuchen, betreffend die Aufweitung und die Ätzraten der sich aus den angegebenen Zusammensetzungen ergebenden Kombinationen, angegeben. Anhand von drei Figuren wird das erfindungsgemäße Verfahren näher erläutert. Die Figuren zeigen im schematischen Querschnitt verschiedene Verfahrensstufen bei der Aufweitung einer Topresiststruktur und der nachfolgenden Strukturübertragung durch einen anisotropen Ätzschritt.

1. Herstellung der Topresistzusammensetzung T1

Durch Auflösen von 16 Gewichtsteilen (GT) eines Copolymeren aus Allyltrimethylsilan und Maleinsäureanhydrid als Basispolymer und 4 GT eines Diesters der Naphthochinondiazid-4-sulfonsäure mit Bisphenol A als photoaktive Komponente in 80 GT (2-Methoxy-1-propyl)-acetat (= MPA) als Lösungsmittel wird der Photoresist T1 hergestellt.

2. Herstellung der Topresistzusammensetzung T2

Der siliziumfreie Topresist T2 wird durch Auflösen von 16 GT eines Copolymeren aus Styrol und Maleinsäureanhydrid sowie 4 GT des bei T1 verwendeten Diesters als photoaktive Komponente in 80 GT MPA dargestellt.

Darstellung des Aufweitungsagens A1

Durch Mischen von 2,5 GT bis (3-Aminopropyl)-tetramethyldisiloxan, 14 GT Isopropanol und 83,5 GT Wasser wird ein siliziumhaltiges Aufweitungsagens A1 dargestellt.

Darstellung des Aufweitungsagens A2

Durch Mischen von 8 GT eines linearen Oligo-Dimethylsiloxans mit endständigen Aminopropylgruppierungen, 80 GT Isopropanol und 12 GT Wasser erhält man das siliziumhaltige Aufweitungsagens A2.

Aufweitungsagens A3

Durch Mischen von 5 GT 1,10-Diaminodecan, 40 GT Isopropanol und 55 GT Wasser wird ein siliziumfreies Aufweitungsagens A3 hergestellt.

Darstellung eines aromatenhaltigen Aufweitungswagens A4

Durch Auflösen von 10 Gewichtsteilen 1,3-Diaminoethylbenzol in 80 Gewichtsteilen Isopropanol und 10 Gewichtsteilen Wasser wird eine aromatenhaltige Aufweitungslösung hergestellt.

Vorversuch:

Aufdicken von unstrukturierten Topresistschichten und Bestimmung der Ätzraten im $O_2$-RIE-Ätzplasma.

Ein mit einer 1,8 μm dicken und 210°C ausgeheizten Schicht des Photoresists MP1450J als planarisierendem Bottomresist beschichteter Wafer wird durch Aufschleudern und anschließendes Trocknen bei 110°C mit einer entsprechenden Topresist derart beschichtet, daß eine Schichtdicke von 0,5 μm entsteht.

Jeweils einer mit dem Topresist T1 bzw. T2 beschichteter Wafer wird jeweils 60 Sekunden in eine der angegebenen Aufweitungsagensien A1, A2 oder A3 eingetaucht, anschließend 30 Sekunden in einem Isopropanol/Wassergemisch

gespült und getrocknet. In einem Plasmareaktor werden die Wafer in einem Sauerstoffplasma (6 mTorr Gasdruck, 410 V Bias) geätzt. Die nachfolgende Tabelle stellt die gemessenen Schichtzuwächse durch die Behandlung mit dem jeweiligen Aufweitungsagens sowie die Ätzraten dar.

Tabelle 1:

| Schichtzuwachs und Ätzraten | | | | |
|---|---|---|---|---|
| | | nach 60s Behandlung in | | |
| | unbehandelt | **LösungA1** (siliziumhaltig) | **LösungA2** (siliziumhaltig) | **LösungA3** (siliziumfrei) |
| **Topresist T1** (siliziumhaltig) | - (2,2 nm/min) | 235 nm (1,0 nm/min) | 275 nm (0,4 nm/min) | 243 nm (3,9 nm/min) |
| **Topresist T2** (siliziumfrei) | - (36 nm/min) | 190 nm (2,1 nm/min) | 210 nm (0,8 nm/min) | - - |

Die Ätzrate des Bottomresists betrug 28 nm/min.

1. Ausführungsbeispiel

Ein wie angegeben mit dem Topresist T1 und dem Bottomresist beschichteter Wafer wird durch eine Maske mit einer Dosis von 90 $mJ/cm^2$ bei 257 nm kontaktbelichtet und anschließend mit einer Entwicklerlösung aus 1 GT käuflicher Entwickler AZ400K, 5 GT Wasser und 0,5 GT Ammoniak solange entwickelt (40 bis 60 Sekunden), daß die Strukturbreiten der Topresiststrukturen jeweils um 0,1 µm geringer sind als auf der Maske vorgegeben.

Der so strukturierte Wafer wird nun solange in das Aufweitungsagens A1 getaucht, daß nach Abspülen und Trocknen die ermittelten Breiten der aufgeweiteten Topresiststrukturen jeweils um 0,05 µm größer sind als auf der Maske vorgegeben. Dieser Wert wird nach ca. 20 bis 60 Sekunden erreicht.

Die aufgeweiteten Topresiststrukturen werden nun unter den bereits angegebenen $O_2$-RIE-Bedingungen im Plasmareaktor in den Bottomresist übertragen. Die nachfolgende Tabelle 2 stellt die ermittelten Strukturbreiten von aufgeweiteten und geätzten Resiststrukturen den auf der Maske vorgegebenen Strukturen gegenüber.

Tabelle 2:

| Strukturbreiten (um) | | | |
|---|---|---|---|
| auf der Maske | der entwickelten Topresiststrukturen (Stege) | der aufgeweiteten Topresiststrukturen (Stege) | der Bottomresiststrukturen (Stege) |
| 2,00 | 1,90 | 2,05 | 2,00 |
| 1,00 | 0,90 | 1,05 | 1,00 |
| 0,50 | 0,40 | 0,55 | 0,50 |

2. Ausführungsbeispiel

Der Versuch vom ersten Ausführungsbeispiel wird mit der Ausnahme wiederholt, daß zur Strukturaufweitung die Lösung A2 verwendet wird und die Topresiststrukturen nach der Aufweitung um 0,02 µm breiter sind als die auf der Maske vorgegebenen Strukturen. Die nachfolgende Tabelle stellt wiederum die gemessenen Strukturbreiten einander gegenüber.

Tabelle 3:

| Strukturbreiten (um) | | | |
|---|---|---|---|
| auf der Maske | der entwickelten Topresiststrukturen (Stege) | der aufgeweiteten Topresiststrukturen (Stege) | der Bottomresiststrukturen (Stege) |
| 2,00 | 1,90 | 2,02 | 2,00 |
| 1,00 | 0,90 | 1,02 | 1,00 |
| 0,50 | 0,40 | 0,52 | 0,50 |

3. Ausführungsbeispiel

Entsprechend dem ersten Ausführungsbeispiel wird ein Wafer beschichtet und strukturiert, mit dem Aufweitungsagens A3 solange behandelt, daß die aufgeweiteten Strukturen um 0,1 µm breiter sind als auf der Maske vorgegeben. Nach einer entsprechenden Ätzung werden die in der Tabelle 4 einander gegenübergestellten Strukturbreiten gemessen.

Tabelle 4:

| Strukturbreiten (um) | | | |
|---|---|---|---|
| auf der Maske | der entwickelten Topresiststrukturen (Stege) | der aufgeweiteten Topresiststrukturen (Stege) | der Bottomresiststrukturen (Stege) |
| 2,00 | 1,90 | 2,10 | 2,00 |
| 1,00 | 0,90 | 1,10 | 1,00 |
| 0,50 | 0,40 | 0,60 | 0,50 |

4. Ausführungsbeispiel

Entsprechend dem ersten Ausführungsbeispiel wird ein mit T2 beschichteter Wafer strukturiert und mit dem Aufweitungsagens A1 so aufgeweitet, daß die Strukturen um 0,06 µm breiter sind als auf der Maske vorgegeben. Die ermittelten Strukturbreiten der Top- bzw. Bottomresiststrukturen werden in der Tabelle 5 den auf der Maske vorgegebenen Strukturen gegenübergestellt.

Tabelle 5:

| Strukturbreiten (um) | | | |
|---|---|---|---|
| auf der Maske | der entwickelten Topresiststrukturen (Stege) | der aufgeweiteten Topresiststrukturen (Stege) | der Bottomresiststrukturen (Stege) |
| 2,00 | 1,90 | 2,06 | 2,00 |
| 1,00 | 0,90 | 1,06 | 1,00 |
| 0,50 | 0,40 | 0,56 | 0,50 |

5. Ausführungsbeispiel

Entsprechend dem vierten Ausführungsbeispiel wird mit der Ausnahme vorgegangen, daß zur Strukturaufweitung das Aufweitungsagens A2 verwendet wird und die Aufweitung Strukturen erzeugt, die um 0,04 µm breiter sind, als auf der Maske vorgegeben. Die Tabelle 6 zeigt die ermittelten Strukturbreiten.

Tabelle 6:

| Strukturbreiten (um) | | | |
|---|---|---|---|
| auf der Maske | der entwickelten Topresiststrukturen (Stege) | der aufgeweiteten Topresiststrukturen (Stege) | der Bottomresiststrukturen (Stege) |
| 2,00 | 1,90 | 2,04 | 2,00 |
| 1,00 | 0,90 | 1,04 | 1,00 |
| 0,50 | 0,40 | 0,54 | 0,50 |

6. Ausführungsbeispiel:

Drei unter Beispiel 1 mit Bottomresist und Topresist I1 beschichtete Wafer werden durch eine Maske, die Linienstrukturen von 2,0 bis 0,5 µm (Steg/Graben) besitzt, mit einer Dosis von 90 $mJ/cm^2$ bei 365 nm kontaktbelichtet und anschließend in einer Mischung aus einem Gewichtsteil Entwickler AZ 400 K (Hoechst AG), 5 Gewichtsteilen Wasser und 0,5 Gewichtsteilen Ammoniak so lange entwickelt, bis die durch Rasterelektronenmikroskopaufnahmen ermittelten Breiten der Resiststege um jeweils 0,1 µm geringer sind als die auf der Maske vorgegebenen Stege.

Die so vorbehandelten Wafer werden nun jeweils 20, 40 bzw. 65 Sekunden in die Lösung A2 eingetaucht, 30 Sekunden in einem Gemisch aus 70 Gewichtsteilen Isopropanol und 30 Gewichtsteilen Wasser gespült und bei 110°C

auf der Hotplate getrocknet. Anhand von REM-Aufnahmen läßt sich erkennen, daß mit zunehmender Behandlungsdauer die Breiten der Resiststege um jeweils 0,15, 0,30 bzw. 0,50 µm zugenommen haben. Die Breiten der entsprechenden Gräben wurden um den entsprechenden Betrag verringert. Die Tabelle 7 gibt die gemessenen Strukturbreiten bzw. die Verhältnisse von Steg/Graben-Dimensionen wider.

Die Strukturübertragung der so aufgeweiteten Topresiststrukturen in den darunterliegenden Bottomresist erfolgt in einem Plasmareaktor unter anisotropen $O_2$/RIE-Bedingungen (6 mTorr $O_2$-Gasdruck, 410 V Bias). Der laterale Maßverlust unter diesen Ätzbedingungen beträgt 0,05 µm.

Tabelle 7:

| Veränderung der Strukturdimensionen von Steg/Grabenmustern nach Behandlung im Aufweitungsagens und $O_2$RIE-Strukturübertragung | | | | |
|---|---|---|---|---|
| Maske Steg/ Graben (um) | Topresist Steg/ Graben (nach Entwicklung) (um) | Behandlungszeit im Aufweitungsagens (s) | Topresist Steg/ Graben (nach Behandlung) (um) | Bottomresist Steg/ Graben (nach O2/RIE) (um) |
| 2.00/2.00 | 1.90/2.10 | 20 | 2.05/1.95 | 2.00/2.00 |
| 1.00/1.00 | 0.90/1.10 | 20 | 1.05/0.95 | 1.00/1.00 |
| 0.50/0.50 | 0.40/0.60 | 20 | 0.55/0.45 | 0.50/0.50 |
| 2.00/2.00 | 1.90/2.10 | 40 | 2.20/1.80 | 2.15/1.85 |
| 1.00/1.00 | 0.90/1.10 | 40 | 1.20/0.80 | 1.15/0.85 |
| 0.50/0.50 | 0.40/0.60 | 40 | 0.70/0.30 | 0.65/0.35 |
| 2.00/2.00 | 1.90/2.10 | 65 | 2.40/1.60 | 2.35/1.65 |
| 1.00/1.00 | 0.90/1.10 | 65 | 1.40/0.60 | 1.35/0.65 |
| 0.50/0.50 | 0.40/0.60 | 65 | 0.90/0.10 | 0.85/0.15 |

7. Ausführungsbeispiel:

Strukturierung des Topresists mit nachfolgender Strukturaufweitung und $O_2$ RIE-Strukturübertragung in den Bottomresist.

Das sechste Ausführungsbeispiel wird mit der Ausnahme wiederholt, daß zur Strukturierung des Topresists eine Maske mit Lochstrukturen von 2,0 bis 0,5 µm Durchmesser und eine Belichtungsdosis von 110 mJ/cm$^2$ verwendet wird. Mit dem im Beispiel 1a beschriebenen Entwickler wird solange entwickelt, daß die anhand von REM-Aufnahmen ermittelten Durchmesser der bis zu 0,5 µm aufgelösten Löcher jeweils um 0,1 µm größer sind als die auf der Maske vorgegebenen Lochstrukturen.

Die so vorbehandelten Wafer werden nun jeweils 20, 40 bzw. 65 Sekunden in die Lösung A2 eingetaucht, 30 Sekunden in einem Gemisch aus 70 Gewichtsteilen Isopropanol und 30 Gewichtsteilen Wasser gespült und bei 110°C auf der Hotplate getrocknet. Anhand von REM-Aufnahmen läßt sich erkennen, daß mit zunehmender Behandlungsdauer die Durchmesser der Top-resistlöcher um jeweils 0,15, 0,30 bzw. 0,50 µm abgenommen haben (siehe Tabelle 8). Die Strukturübertragung im Sauerstoff/ RIE-Plasma erfolgt wie im Beispiel 1 beschrieben. Die Tabelle 2 zeigt die in REM-Aufnahmen ermittelten Strukturdimensionen der Resiststrukturen vor und nach der Aufweitungsbehandlung sowie die Strukturen des Bottomresists nach der Strukturübertragung.

Tabelle 8:

| Veränderung der Lochdurchmesser nach Behandlung im Aufweitungsagens und $O_2$RIE-Strukturübertragung | | | | |
|---|---|---|---|---|
| Maske (um) | Topresist (nach Entwicklung) (um) | Behandlungszeit im Aufweitungsagens (s) | Topresist (nach Behandlung) (um) | Bottomresist (nach $O_2$RIE) (um) |
| 2.00 | 2.10 | 20 | 1.95 | 2.00 |
| 1.00 | 1.10 | 20 | 0.95 | 1.00 |
| 0.50 | 0.60 | 20 | 0.45 | 0.50 |
| 2.00 | 2.10 | 40 | 1.80 | 1.85 |
| 1.00 | 1.10 | 40 | 0.80 | 0.85 |
| 0.50 | 0.60 | 40 | 0.30 | 0.35 |

Tabelle 8: (fortgesetzt)

| Veränderung der Lochdurchmesser nach Behandlung im Aufweitungsagens und $O_2$RIE-Strukturübertragung | | | | |
|---|---|---|---|---|
| Maske (um) | Topresist (nach Entwicklung) (um) | Behandlungszeit im Aufweitungsagens (s) | Topresist (nach Behandlung) (um) | Bottomresist (nach $O_2$RIE) (um) |
| 2.00 | 2.10 | 65 | 1.60 | 1.65 |
| 1.00 | 1.10 | 65 | 0.60 | 0.65 |
| 0.50 | 0.60 | 65 | 0.10 | 0.15 |

8. Ausführungsbeispiel:

Eine Photoresistlösung T2 wird unter solchen Bedingungen auf einen 3-Zoll-Wafer aufgeschleudert, daß nach der Trocknung bei 110°C ein Resistfilm mit einer Schichtdicke von 1,0 µm entsteht.

Der beschichtete Wafer wird durch eine Maske, die Linienstrukturen von 2,0 bis 0,5 µm (Steg/Graben) besitzt, mit einer Dosis von 100 $mJ/cm^2$ bei 365 nm kontaktbelichtet und anschließend mit einer Mischung aus einem Gewichtsteil Entwickler AZ 400 K, 5 Gewichtsteilen Wasser und 0,5 Gewichtsteilen Ammoniak solange entwickelt, daß die anhand von REM-Aufnahmen ermittelten Breiten der bis zu 0,5 µm aufgelösten Resiststege mit den auf der Maske vorgegebenen Stegbreiten übereinstimmen.

Der Wafer wird nun für 60 Sekunden in die Aufweitungslösung A4 eingetaucht, 30 Sekunden in einem Gemisch aus Isopropanol und Wasser gespült und bei 110°C getrocknet. Anhand von REM-Aufnahmen läßt sich erkennen, daß die Breiten der Resiststege jeweils um 0,3 µm zugenommen und die der Resistgräben um 0,3µm abgenommen haben (siehe Tabelle 9).

Tabelle 9:

| Veränderung der Strukturdimensionen von Steg/Grabenmustern nach Behandlung im Aufweitungsagens | | |
|---|---|---|
| Strukturbreiten | | |
| Maske Steg/Graben (um) | Resist Steg/Graben (nach Entwicklung) (um) | Resist Steg/Graben (nach 60s Behandlung in Aufweitungslösung) (um) |
| 2.00/2.00 | 2.00/2.00 | 2.30/1.70 |
| 1.00/1.00 | 1.00/1.00 | 1.30/0.70 |
| 0.50/0.50 | 0.50/0.50 | 0.80/0.20 |

Gut zu erkennen ist, daß unabhängig von Steg/Graben-Dimension die Aufweitung der Stege bzw. die Verengung der Gräben lediglich von der Behandlungsdauer abhängig ist. Das zeigt, daß sich das erfindungsgemäße Verfahren ausgezeichnet steuern läßt. Dies ist für eine maßstabsgetreue Strukturübertragung von größter Bedeutung.

Figurenbeschreibung:

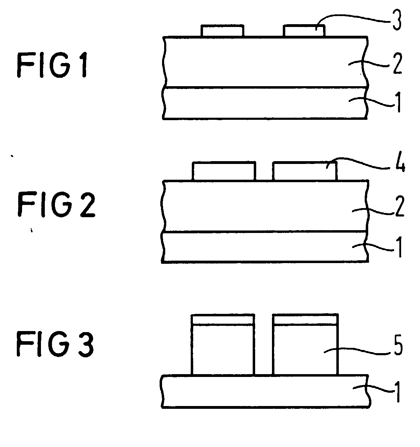

Entsprechend zum Beispiel dem ersten Ausführungsbeispiel stellt Figur 1 ein mit einem Bottomresist 2 beschichtetes Substrat 1 dar, auf dem sich bereits entwickelte Topresiststrukturen 3 befinden. Nach der chemischen Aufweitung werden breitere als auch dickere Strukturen 4 erhalten, wie in Figur 2 dargestellt. Im $O_2$/RIE-Plasma wird die Anordnung anisotrop geätzt, wobei die mit den als Ätzmaske dienenden Strukturen 4 abgedeckten Bottomresiststrukturen 5 erhalten werden, die in Figur 3 dargestellt sind. Der (gegenüber der Maske, bzw. den in Figur 1 gezeigten Strukturen 3) verengte Graben zwischen den dargestellten Strukturen 5 weist steile Flanken auf.

**Patentansprüche**

**1.** Verfahren zur Verbreiterung einer Photoresiststruktur, bei dem

- auf einem Substrat ein Photoresist aufgebracht, belichtet und entwickelt wird, wobei die so entstandene Photoresiststruktur noch funktionelle Gruppen aufweist, die für die chemische Anbindung einer weiteren Verbindung geeignet sind, die ausgewählt sind aus Anhydrid, Epoxid, Polyurethan, Poly(meth)acrylat, Polyester, Polyether, Amid, Phenol und Thioester,

- die Photoresiststruktur mit einem Aufweitungsagens behandelt wird, wobei die im Aufweitungsagens enthaltene Aufweitungskomponente mit den funktionellen Gruppen in der Photoresiststruktur eine chemische Verknüpfung eingeht, wobei die zur Reaktion geeignete chemische Funktion der Aufweitungskomponente eine Hydroxyl- oder Aminogruppe ist, und wobei ein Volumenzuwachs der Photoresiststruktur erzielt wird und
- das Ausmaß der durch den Volumenzuwachs bedingten lateralen Verbreiterung der Resiststrukturen im Bereich von einigen Nanometern bis einige Mikrometer einstellbar ist durch zumindest eine der Maßnahmen a), b) und c):

  a) Erhöhung der Konzentration der Aufweitungskomponente im Aufweitungsagens

  b) Erhöhung der Temperatur bei der Behandlung mit dem Agens

  c) Erhöhung der Behandlungsdauer mit dem Agens.

**2.** Verfahren nach Anspruch 1,
**dadurch gekennzeichnet**,
daß die Aufweitungskomponente in wäßriger oder zumindest mit Wasser enthaltender Lösung oder Emulsion eingesetzt wird.

**3.** Verfahren nach Anspruch 1,
**dadurch gekennzeichnet**,
daß das Aufweitungsagens in der Gasphase eingesetzt wird.

**4.** Verfahren nach Anspruch 2,
**dadurch gekennzeichnet**,
daß die Aufweitungskomponente hydrolysestabil ist und in einer wäßrig-alkoholischen Lösung eingesetzt wird.

**5.** Verfahren nach mindestens einem der Ansprüche 1 bis 4,
**dadurch gekennzeichnet**,
daß die Behandlung mit dem Aufweitungsagens bei Normaldruck und Raumtemperatur durchgeführt wird.

**6.** Verfahren nach mindestens einem der Ansprüche 1 bis 5,
**dadurch gekennzeichnet**,
daß vor der Behandlung mit dem Agens eine Flutbelichtung der Photoresiststruktur durchgeführt wird.

**7.** Verfahren nach einem der Ansprüche 1 bis 6,
**dadurch gekennzeichnet**,
daß mit einer siliziumhaltigen Aufweitungskomponente die Ätzresistenz gegen ein sauerstoffhaltiges Ätzplasma verstärkt wird.

**8.** Verfahren nach Anspruch 1 bis 6,
**dadurch gekennzeichnet**,
daß eine aromatische Gruppen aufweisende Aufweitungskomponente verwendet wird, um die Ätzresistenz gegen ein halogenhaltiges Plasma zu verstärken.

**9.** Verfahren nach einem der Ansprüche 1 bis 8,
**dadurch gekennzeichnet**,
daß die Aufweitung mit einer strukturvernetzenden Aufweitungskomponente durchgeführt wird, um die thermisch/mechanische Belastbarkeit der Photoresiststruktur zu erhöhen.

**10.** Verfahren nach mindestens einem der Ansprüche 1 bis 9,
**dadurch gekennzeichnet**,
daß die Behandlung der Photoresiststruktur in einem Sprüh-, Puddle- oder Tauchentwickler vorgenommen wird.

**11.** Verfahren nach einem der Ansprüche 1 bis 10,
**dadurch gekennzeichnet**,
daß eine Zweilagentechnik verwendet wird, die Resiststruktur zunächst im Topresist erzeugt wird und mit einem

Plasmaätzverfahren auf den Bottomresist übertragen wird, wobei durch die vor der Übertragung vorzunehmende Aufweitung der Topresiststruktur ein Maßvorhalt erzeugt wird, der genau dem Maßverlust beim Plasmaätzverfahren entspricht.

**12.** Verfahren nach Anspruch 1,
**dadurch gekennzeichnet**,
daß für einen anhydridhaltigen Resist als Aufweitungsagens ein Aminosiloxan mit 1 bis 50, vorzugsweise 2 bis 12 Siliziumatomen verwendet wird.

**13.** Verfahren zur lithographischen Erzeugung von Strukturen mit einer Grabenbreite, die unterhalb der optischen Auflösung einer gegebenen Abbildungstechnik liegt, unter Verbreiterung der Photoresiststruktur gemäß Anspruch 1, bei dem ein aus A und B bestehendes Photoresistsystem verwendet wird:

A) einem Photoresist, welcher nach der Strukturierung pro regelmäßig wiederkehrender Struktureinheit zumindest eine reaktive Gruppe enthält, welche ausgewählt ist aus der Gruppe, umfassend Anhydrid, Epoxid, Polyurethan, Poly(meth)acrylat, Polyester und Polyether, sowie

B) einem Aufweitungsagens zur Erzielung eines Volumenzuwachses einer aus A) bestehenden Resiststruktur mit einhergehender lateraler Strukturverbreiterung, wobei die im Aufweitungsagens enthaltene Aufweitungskomponente pro Molekül zumindest eine chemische Funktion aufweist, die zur Reaktion mit einer reaktiven Gruppe von A) geeignet ist.

**14.** Verfahren nach Anspruch 13,
**dadurch gekennzeichnet**,
daß die Komponente A) zumindest einer der allgemeinen folgenden Strukturen gehorcht:

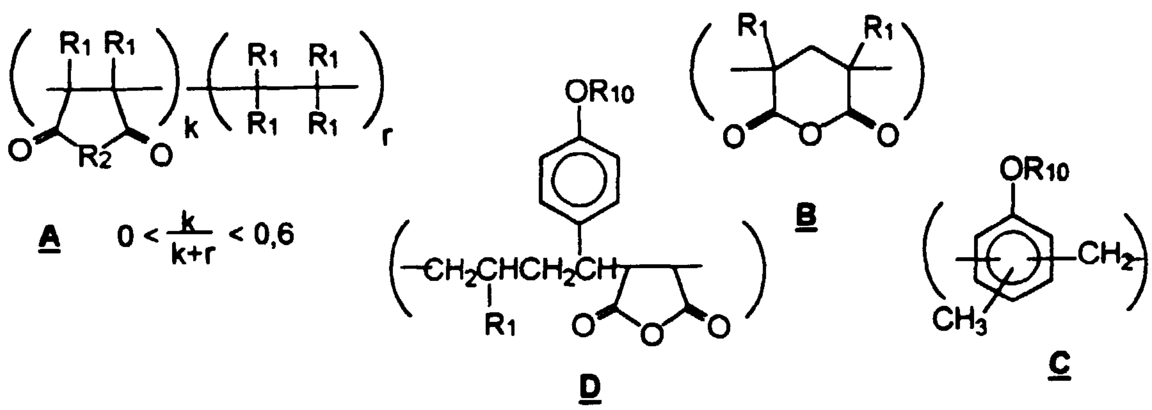

A $0 < \frac{k}{k+r} < 0,6$

D

B

C

wobei

$R^1$ gleich H, Alkyl, Aryl, Halogen, Halogen-substituiertes Alkyl bzw. Aryl,

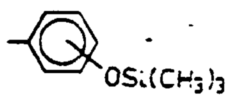 , 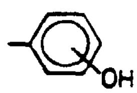 , 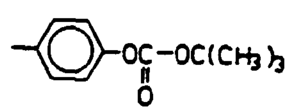 ,

-COOH, -COOR, $-CH_2Si(CH_3)_3$, $-Si(CH_3)_3$, $-Si(OCH_3)_3$,

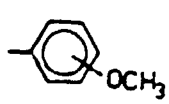

$R^2$ gleich O, NH, S,
$R^5$ gleich H, $CH_3$ und
$R^{10}$ gleich H oder

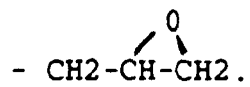

**Claims**

1. Method for widening a photoresist structure, in which

   - a photoresist is deposited on a substrate, exposed and developed, the photoresist structure produced in this way still having functional groups which are suitable for chemically bonding a further compound which are [sic] selected from anhydride, epoxide, polyurethane, poly(meth)acrylate, polyester, polyether, amide, phenol and thioester,
   - the photoresist structure is treated with an expanding agent, the expanding component contained in the expanding agent entering into a chemical coupling with the functional groups in the photoresist structure, the chemical function suitable for the reaction in the expanding component being a hydroxyl group or an amino group and a volume increase in the photoresist structure being achieved and
   - the extent of the lateral widening of the resist structures caused by the increase in volume is adjustable in the range from a few nanometres to a few micrometres by means of at least one of the measures a), b) and c):

     a) increasing the concentration of the expanding component in the expanding agent
     b) increasing the temperature during the treatment with the agent
     c) increasing the treatment time with the agent.

2. Method according to Claim 1, characterized in that the expanding component is used in aqueous solution or at least with a water-containing solution or emulsion.

3. Method according to Claim 1, characterized in that the expanding agent is used in the gas phase.

4. Method according to Claim 2, characterized in that the expanding component is resistant to hydrolysis and is used in an aqueous alcoholic solution.

5. Method according to at least one of Claims 1 to 4, characterized in that the treatment with the expanding agent is carried out at normal pressure and room temperature.

6. Method according to at least one of Claims 1 to 5, characterized in that, prior to the treatment with the agent, a flood exposure of the photoresist structure is carried out.

7. Method according to one of Claims 1 to 6, characterized in that the etching resistance to an oxygen-containing etching plasma is intensified using a silicon-containing expanding component.

8. Method according to Claims 1 to 6, characterized in that an expanding component containing aromatic groups is used to intensify the etching resistance to a halogen-containing plasma.

9. Method according to one of Claims 1 to 8, characterized in that the expansion is carried out with a structure-crosslinking expanding component in order to increase the thermal/mechanical loading capacity of the photoresist structure.

10. Method according to at least one of Claims 1 to 9, characterized in that the treatment of the photoresist structure is carried out in a spray developer, puddle developer or immersion developer.

11. Method according to one of Claims 1 to 10, characterized in that a two-layer technique is used, the resist structure is first produced in the top resist and transferred to the bottom resist by means of a plasma etching method, a

dimensional allowance which precisely corresponds to the dimensional loss during the plasma etching method being produced by the expansion to be carried out prior to the transfer.

**12.** Method according to Claim 1, characterized in that an aminosiloxane containing 1 to 50, preferably 2 to 12 silicon atoms is used as expanding agent for an anhydride-containing resist.

**13.** Method for the lithographic production of structures having a trench width which is below the optical resolution of a given imaging technique, involving widening of the photoresist structure according to Claim 1, in which method a photoresist system composed of A and B is used:

A) a photoresist which, after structuring, contains at least one reactive group for each regularly repeating structural unit, which reactive group is selected from the group comprising anhydride, epoxide, polyurethane, poly(meth)acrylate, polyester and polyether, and also
B) an expanding agent for achieving a volume increase of a resist structure composed of A) with accompanying lateral structure widening, the expanding component contained in the expanding agent having at least one chemical function in each molecule, which chemical function is suitable for the reaction with a reactive group of A).

**14.** Method according to Claim 13, characterized in that the component A) belongs to at least one of the following general structures:

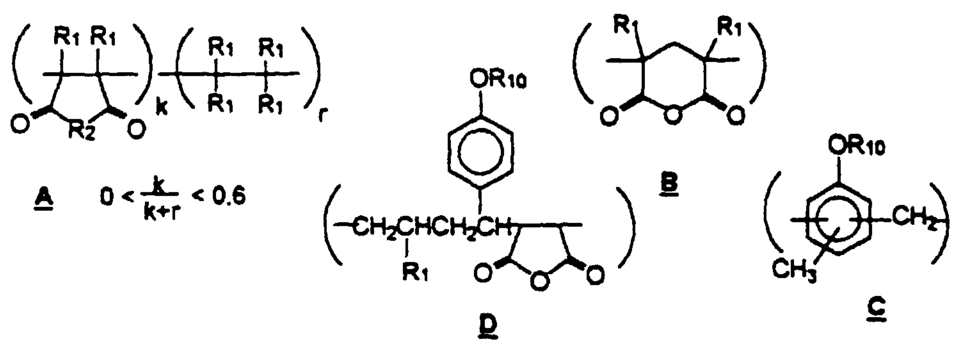

A $0 < \frac{k}{k+r} < 0.6$ D B C

where

$R^1$ is equal to H, alkyl, aryl, halogen, halogen-substituted alkyl or aryl,

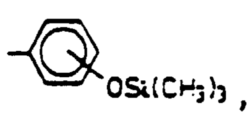 , 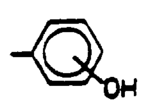 , 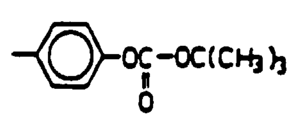 ,

-COOH, -COOR, $-CH_2Si(CH_3)_3$, $-Si(CH_3)_3$, $-Si(OCH_3)_3$,

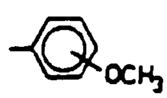

$R^2$ is equal to O, NH, S,
$R^5$ is equal to H, $CH_3$ and
$R^{10}$ is equal to H or

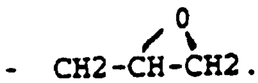

## Revendications

**1.** Procédé d'élargissement d'une structure de photoréserve, au cours duquel

- on applique, on expose et on développe une photoréserve sur un substrat, la structure de photoréserve ainsi formée présentant encore des groupes fonctionnels qui sont appropriés pour une liaison chimique d'un composé supplémentaire qui est choisi parmi les anhydrides, les époxydes, les polyuréthanes, les poly(méth) acrylates, les polyesters, les polyéthers, les amides, le phénol et le thioester,
- la structure de photoréserve est traitée avec un agent d'extension, la composante d'extension contenue dans l'agent d'extension formant une liaison chimique avec les groupes fonctionnels dans la structure de photoréserve, la fonction chimique de la composante d'extension, appropriée pour la réaction étant un groupe hydroxyle ou un groupe amino, et une augmentation de volume de la structure de photoréserve étant obtenue et
- le degré de l'élargissement latéral des structures de réserve dû à l'augmentation de volume étant réglable dans la gamme de quelques nanomètres à quelques micromètres grâce à au moins une des mesures a), b) et c) :

    a) l'augmentation de la concentration de la composante d'extension dans l'agent d'extension
    b) l'augmentation de la température lors du traitement avec l'agent chimique
    c) l'augmentation de la durée de traitement avec l'agent chimique.

**2.** Procédé selon la revendication 1, caractérisé en ce que la composante d'extension est utilisée dans une solution ou dans une émulsion aqueuse ou contenant du moins de l'eau.

**3.** Procédé selon la revendication 1, caractérisé en ce que l'agent d'extension est utilisé en phase gazeuse.

**4.** Procédé selon la revendication 2, caractérisé en ce que la composante d'extension est stable à l'hydrolyse et est utilisée dans une solution aqueuse-alcoolique.

**5.** Procédé selon au moins une des revendications 1 à 4, caractérisé en ce que le traitement avec l'agent d'extension est effectué à pression normale et à température ambiante.

**6.** Procédé selon au moins une des revendications 1 à 5, caractérisé en ce qu'on effectue avant le traitement avec l'agent chimique une exposition par projection de la structure de photoréserve.

**7.** Procédé selon une des revendications 1 à 6, caractérisé en ce qu'on renforce, avec une composante d'extension contenant du silicium, la résistance à la gravure vis-à-vis d'un plasma de gravure contenant de l'oxygène.

**8.** Procédé selon la revendication 1 à 6, caractérisé en ce qu'on utilise une composante d'extension présentant des groupes aromatiques, pour augmenter la résistance à la gravure vis-à-vis d'un plasma contenant des halogènes.

**9.** Procédé selon l'une des revendications 1 à 8, caractérisé en ce que l'extension est réalisée avec une composante d'extension de réticulation des structures pour augmenter la capacité de charge thermomécanique de la structure de photoréserve.

**10.** Procédé selon au moins une des revendications 1 à 9, caractérisé en ce que le traitement de la structure de photoréserve est effectué dans un appareil de développement par aspersion, de type Puddle ou par immersion.

**11.** Procédé selon l'une des revendications 1 à 10, caractérisé en ce qu'on utilise une technique à double couche, en ce que la structure de réserve est d'abord réalisée dans la topréserve et en ce qu'elle est transférée dans un procédé de gravure au plasma dans la bottomréserve, étape par laquelle on réalise un gain dimensionnel par l'extension de la structure de topréserve à réaliser avant le transfert, qui correspond exactement à la perte dimensionnelle lors du procédé de gravure au plasma.

**12.** Procédé selon la revendication 1, caractérisé en ce qu'on utilise pour une réserve contenant un anhydride à titre d'agent d'extension un aminosiloxane avec 1 à 50, de préférence 2 à 12 atomes de silicium.

**13.** Procédé pour la création par voie lithographique de structures avec une largeur de fossé qui se situe en dessous de la résolution optique d'une technique de reproduction donnée, en élargissant la structure de photoréserve conformément à la revendication 1, dans lequel on utilise un système de photo réserve constitué de A et de B :

A) une photoréserve qui contient, après la structuration par unité de structure répétitive, au moins un groupe réactionnel qui est choisi parmi le groupe comprenant les anhydrides, les époxydes, les polyuréthanes, les poly(méth)acrylates, les polyesters et les polyéthers, de même que
B) un agent d'extension pour la réalisation d'un accroissement de volume d'une structure de réserve constituée de A) avec un élargissement de structure latérale concomitant, la composante d'extension contenue dans l'agent d'extension présentant par molécule au moins une fonction chimique qui est appropriée pour la réaction avec un groupe réactionnel de A).

**14.** Procédé selon la revendication 13, caractérisé en ce que la composante A) répond à au moins une des structures suivantes :

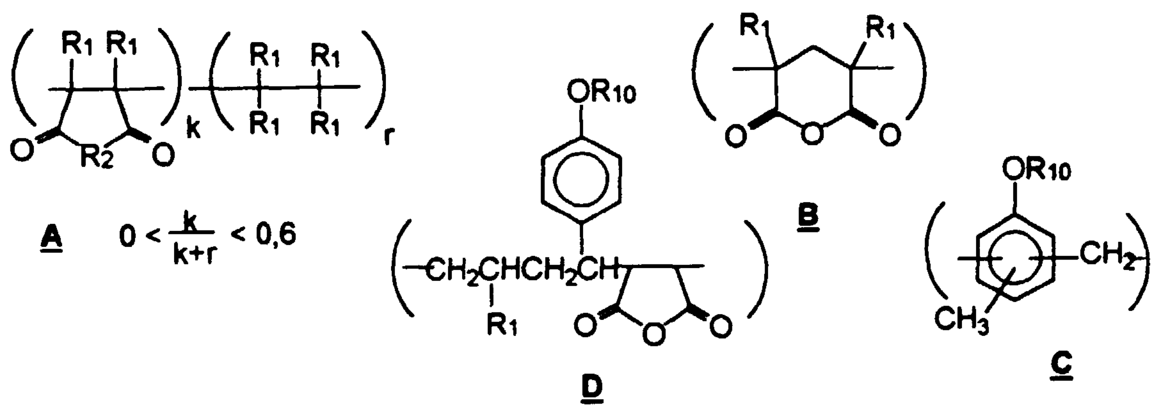

**A** $0 < \frac{k}{k+r} < 0,6$ **B** **C** **D**

où

$R^1$ représente H, un groupe alkyle, un groupe aryle, un atome d'halogène, un groupe alkyle respectivement aryle substitué par un atome d'halogène,

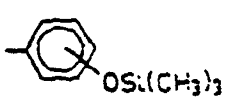, 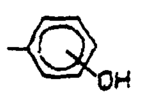, 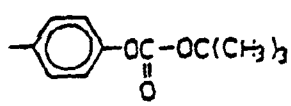,

-COOH, -COOR, $-CH_2Si(CH_3)3$, $-Si(CH_3)_3$, $-Si(OCH_3)_3$,

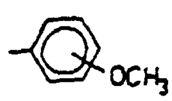

$R^2$ représente O, NH, S,
$R^5$ représente H, $CH_3$ et
$R^{10}$ représente H ou

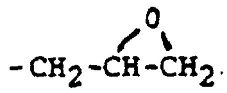

FIG 1

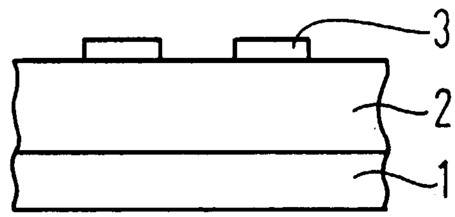


FIG 2

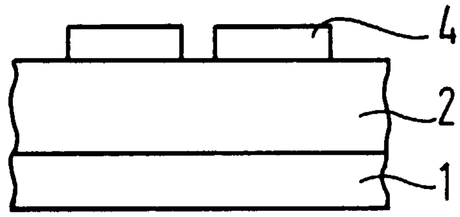


FIG 3